Europäisches Patentamt

European Patent Office

Office européen des brevets

(19)

(11) Veröffentlichungsnummer : **0 326 843 B1**

(12) **EUROPÄISCHE PATENTSCHRIFT**

(45) Veröffentlichungstag der Patentschrift :
**18.03.92 Patentblatt 92/12**

(21) Anmeldenummer : **89100664.5**

(22) Anmeldetag : **16.01.89**

(51) Int. Cl.$^5$ : **C23C 14/54, H01J 37/32**

(54) Beschichtungskammer mit geregelter Zusammensetzung der Gasatmosphäre.

(30) Priorität : **29.01.88 DE 8801079 U**

(43) Veröffentlichungstag der Anmeldung :
**09.08.89 Patentblatt 89/32**

(45) Bekanntmachung des Hinweises auf die
Patenterteilung :
**18.03.92 Patentblatt 92/12**

(84) Benannte Vertragsstaaten :
**AT BE CH DE ES FR GB IT LI LU NL SE**

(56) Entgegenhaltungen :
**DE-A- 1 521 248**
**FR-A- 2 350 639**
**FR-A- 2 371 009**
**FR-A- 2 595 801**
**GB-A- 2 021 294**
**GB-A- 2 180 081**
**US-A- 3 881 093**

(56) Entgegenhaltungen :
**IBM TECHNICAL DISCLOSURE BULLETIN,
Band 20, Nr. 12, Mai 1978, Seiten 5379-5380,
New York, US; P. SILANO: "Automatic pressure control of mixed gases"**
**PATENT ABSTRACTS OF JAPAN, Band 3, Nr.
123 (C-61), 16. Oktober 1979; & JP-A-54 103 790
(NIPPON DENKI) 15-08-1979**
**PATENT ABSTRACTS OF JAPAN, Band 9, Nr.
324 (C-320)[2047], 19. Dezember 1985; & JP-
A-60 155 669 (SHINKUU KIKAI) 15-08-1985**

(73) Patentinhaber : **Multi-Arc Oberflächentechnik
GmbH
Friedrich-Ebert-Strasse
W-5060 Bergisch Gladbach 1 (DE)**

(72) Erfinder : **Maxam, Siegfried
Unterschelmrath 27
W-5250 Engelskirchen (DE)**
Erfinder : **Frink, Lothar
Am Heidberg 5
W-5223 Nümbrecht (DE)**

(74) Vertreter : **Patentanwälte Dipl.-Ing. Alex
Stenger Dipl.-Ing. Wolfram Watzke Dipl.-Ing.
Heinz J. Ring et al
Kaiser-Friedrich-Ring 70
W-4000 Düsseldorf 11 (DE)**

EP 0 326 843 B1

## Beschreibung

Die vorliegende Erfindung betrifft eine Beschichtungskammer mit mindestens einer durch Lichtbogenentladung verzehrbaren Kathode und einer Einrichtung zur Aufnahme von Gegenständen, die durch Niederschlag von Reaktionsprodukten beschichtet werden, die bei der Reaktion des verdampften Kathodenmaterials mit einer Gasatmosphäre entstehen, wobei die Gasatmosphäre aus einem unter veränderlichem Druck stehenden Gemisch von mehreren Gasen besteht.

Eine derartige Kammer wird nach Beladung mit den zu beschichtenden Gegenständen (z.B. Werkzeugen) und anschließender Evakuierung bis zu einem vorbestimmten Druck mit einem Reaktionsgas gefüllt, z.B. mit Stickstoff, das mit dem Kathodenmaterial reagiert, z.B. mit Titan, das durch eine zwischen Kathode und Anode gezündete Lichtbogenentladung in den Plasmazustand überführt worden ist. Das Reaktionsprodukt, im Beispiel Titannitrid, schlägt sich auf den in der Kammer befindlichen Gegenständen in Form einer wenige Mikrometer dicken Schicht nieder. Diese Schicht verleiht den Gegenständen eine gewünschte Eigenschaft, z.B. große Verschleißfestigkeit. Für besondere Anwendungsfälle sind auch Schichten aus einem Gemisch mehrerer Reaktionsprodukte gewünscht, die aus der Reaktion mit verschiedenen Gasen hervorgegangen sind, z.B. neben Stickstoff auch Sauerstoff oder Azetylen. Dazu wird die Kammer mit einem Gemisch dieser Gase von einerseits gleichbleibender Zusammensetzung und andererseits gleichbleibendem oder exakt steuerbarem Gesamtdruck gefüllt.

Die gleichzeitige, aufeinander abgestimmte Einstellung oder Regelung der beiden Parameter Zusammensetzung und Gesamtdruck mittels bekannter Geräte bereitet Schwierigkeiten. Die Aufgabe der vorliegenden Erfindung ist die Überwindung solcher Schwierigkeiten bei einer Beschichtungskammer der eingangs genannten Art.

Diese Aufgabe wird erfindungsgemäß dadurch gelöst, daß ein Druckmeßgerät zur Messung des Istdruckes im Innenraum vorgesehen ist, dem ein Druckregler nachgeschaltet ist, der den Istdruck mit einem vorgegebenen Sollwert vergleicht und an dessen Ausgang eine der Differenz zwischen den beiden Werten entsprechende Ausgangsspannung anliegt, die jeweils dem ersten Eingang eines Multipliziergliedes aufgeschaltet ist, dessen zweiter Eingang jeweils mit einer vorgegebenen, dem gewünschten Anteil des einzelnen Gases an dem Gasgemisch proportionalen Spannung beaufschlagt ist, und daß den Multipliziergliedern jeweils ein Regler nachgeschaltet ist, der jeweils über ein Einstellorgan den Zustrom eines der das Gemisch bildenden Gase in den Innenraum regelt.

Die genannte Einrichtung zur Regelung des Gesamtdruckes in der Beschichtungskammer liefert in Abhängigkeit von der Differenz zwischen dem tatsächlich jeweils in der Kammer herrschenden Gesamtdruckes (Istdruck), der auf eine beliebige konventionelle Weise mit dem Druckmeßgerät gemessen wird, und dem gewünschten Gesamtdruck (Sollwert) ein Ausgangssignal. Der Sollwert kann dabei entsprechend dem Fortschreiten des Beschichtungsprozesses über die Zeit variieren. Das Ausgangssignal wird jeweils getrennt mit einem weiteren, für jede der Gemischkomponenten einzeln erzeugten oder bereitgestellten Signal multipliziert. Dessen Stärke ist proportional gewählt dem gewünschten Anteil des betreffenden Gases an der Gesamtgasmischung. Das aus der Multiplikation resultierende Signal dient zur Ansteuerung desjenigen Reglers, der die Einspeisung der betreffenden Gaskomponente in die Kammer steuert. Auf diese Weise stellt sich in der Beschichtungskammer unabhängig vom gerade herrschenden Druck stets dieselbe vorgewählte prozentuale Zusammensetzung ein.

Beim Beschichten kann ein gradierter Aufbau der Beschichtung, also eine Beschichtung mit sich über die Höhe ändernder Zusammensetzung, gewünscht sein. Für diesen Fall ist nach einer Ausgestaltung der Erfindung vorgesehen, daß die jeweils dem zweiten Eingang des Multiplizierers zugeführten Spannungen zeitlich variiert werden. Dadurch bietet sich die Möglichkeit, nicht nur - wie oben - den einen Faktor, nämlich den Gesamtdruck, entsprechend den Prozeßerfordernissen zu ändern, sondern auch den anderen Faktor, nämlich die Zusammensetzung des Gasgemisches aus seinen einzelnen Komponenten.

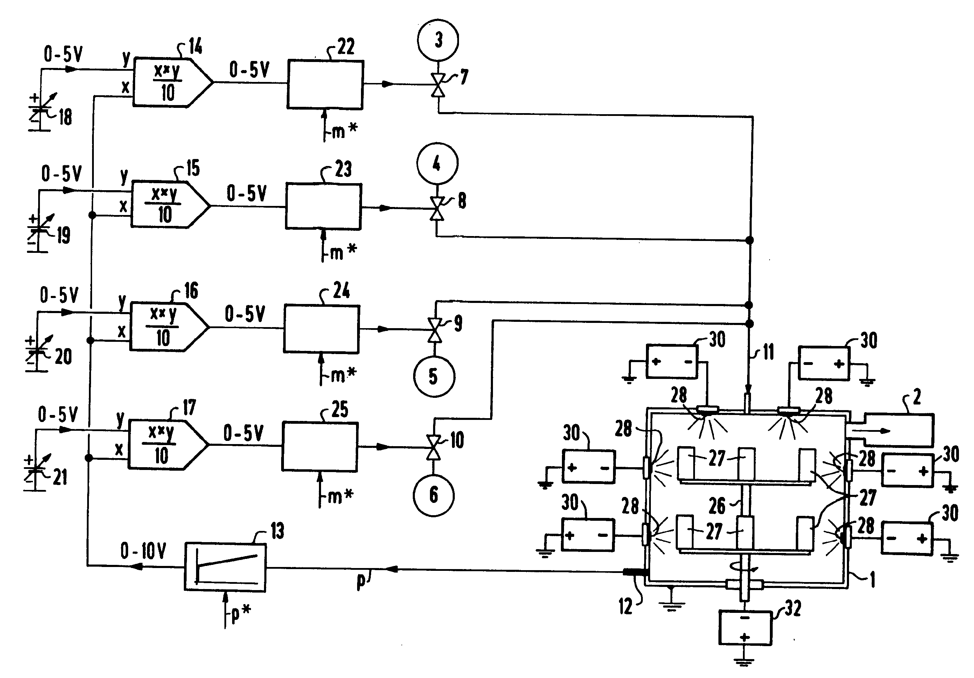

Ein Ausführungsbeispiel der Erfindung ist schematisch in der Zeichnung dargestellt.

Eine Prozeß- oder Beschichtungskammer 1 umfaßt eine Anzahl an der Wand angeordnete Kathoden 28 aus einem vorgegebenen Material, wie z.B. Titan. Mit Hilfe von Spannungsquellen 30 sind die Kathoden 28 auf negatives Potential (gegenüber Erde) gelegt. Die Wand der Beschichtungskammer 1 liegt auf positivem Potential, vorliegend auf Erdpotential.

In der Kammer 1 kann im Betrieb durch Zündung von Lichtbögen zwischen den Kathoden 28 und der als Anode geschalteten Wand das Material der Kathoden 28 verdampft werden.

Die Beschichtungskammer 1 wird zuvor nach Bestückung eines Drehgestells 26 mit den zu beschichtenden Gegenständen 27 mit Hilfe einer Vakuumpumpe 2 evakuiert. Das Drehgestell 26 kann dabei auf dem negativen Potential einer Spannungsquelle 32 liegen. Die Kammer 1 wird anschließend mit einem Gemisch aus 1 bis n (hier: n = 4) einzelnen Gasen gefüllt. Diese Gase, z.B. Stickstoff, Sauerstoff, Azetylen, etc., werden aus

2

entsprechenden Speichern 3 bis 6 nach Öffnen der dazugehörigen Ventile 7 bis 10 in eine Sammelleitung 11 eingegeben, dort gemischt und danach in die Beschichtungskammer 1 geleitet.

Der sich aus der Summe der Einzeldrücke ergebende Gesamtdruck im Innenraum der Beschichtungskammer 1 wird mittels eines Druckmeßgerätes 12 gemessen. Das Meßsignal wird einem Druckregler 13 zugeführt, in dem der herrschende Istdruck p mit einem vorgegebenen, ggf. zeitlich veränderlichen Solldruck p* verglichen wird. Proportional zum Maß der Abweichung (p - p*) dieser beiden Werte voneinander steht am Ausgang des ersten Reglers 13 eine Spannung von beispielsweise 0 bis 10 Volt an. Diese Spannung wird als Eingangssignal x jeweils dem ersten Eingang eines ersten, zweiten, dritten und vierten Multipliziergliedes 14 bis 17 aufgeschaltet. Der jeweils zweite Eingang der Multiplizierglieder 14 bis 17 ist an eine getrennte erste, zweite, dritte bzw. vierte einstellbare Spannungsquelle 18 bis 21 angeschlossen. Die Spannung dieser Spannungsquellen 18 bis 21 liegt z.B. im Bereich von 0 bis 5 Volt. Sie wird als Eingangssignal y dem betreffenden zweiten Eingang zugeführt. In jedem Multiplizierglied 14 bis 17 wird eine Multiplikation nach der Beziehung $(x \cdot y)/10$ vorgenommen, so daß sich ein Ausgangssignal im Bereich von 0 bis 5 Volt ergibt.

Das Ausgangssignal jedes der Multiplizierglieder 14 bis 17 dient als Eingangsgröße für einen ersten, zweiten, dritten bzw. vierten Regler 22 bis 25, der in Abhängigkeit von der Stärke des zugeführten Signals das zugehörige Ventil 7 bis 10 mehr oder weniger weit öffnet. Abweichend von dem hier schematisch dargestellten Aufbau können in der praktischen Ausführung, wie dem Fachmann bekannt, Regler und Ventile zu einer Einheit zusammengefaßt werden.

Die von den Spannungsquellen 18 bis 21 gelieferte Spannung (Eingangssignal y) ist im voraus entsprechend dem gewünschten Anteil des betreffenden Gases an der Gesamtmischung eingestellt. Dieser Anteil wird über das zugehörige Multiplizierglied 14 bis 17 und den nachgeschalteten Regler 22 bis 25 auf dem vorgegebenen Wert automatisch festgehalten. Sollen zum Beispiel das aus dem Speicher 3 stammende Gas in der Gesamtmischung zu 50%, die aus den Speichern 4, 5 stammenden Gase zu je 20% und das aus dem Speicher 6 stammende Gas zu 10% in der Gasmischung in der Beschichtungskammer 1 vertreten sein, so könnten die Ausgangs spannung der ersten Spannungsquelle 18 5 Volt, diejenige der zweiten und dritten Spannungsquelle 19, 20 je 2 Volt und diejenige der vierten Spannungquelle 21 1 Volt betragen. Da Schwankungen der von dem Druckregler 13 abgegebenen Spannung x in gleicher Weise alle Multiplizierer 14 bis 17 beeinflussen, wird der Durchsatz durch die Ventile 7 bis 10 entsprechend vermindert oder vergrößert, wobei das prozentuale Verhältnis zwischen diesen Durchsätzen und damit die Gas-Zusammensetzung erhalten bleibt. Soll dieses prozentuale Verhältnis, d.h. die Gas-Zusammensetzung, selbst verändert werden, so kann dies in einfacher Weise durch Änderung der von den Spannungsquellen 18 bis 21 abgegebenen Spannungen y erreicht werden. Die Veränderung kann dabei in definierter Abhängigkeit von der Zeit, z.B. kontinuierlich, vorgenommen werden. Auf diese Weise läßt sich eine Beschichtung mit variierender Material-Zusammensetzung auf den Gegenständen 27 erreichen.

## Patentansprüche

1. Beschichtungskammer (1) mit mindestens einer durch Lichtbogenentladung verzehrbaren Kathode (28) und einer Einrichtung (26) zur Aufnahme von Gegenständen (27), die durch Niederschlag von Reaktionsprodukten beschichtet werden, die bei der Reaktion des verdampften Kathodenmaterials mit einer Gasatmosphäre entstehen, wobei die Gasatmosphäre aus einem unter veränderlichem Druck (p) stehenden Gemisch von mehreren Gasen besteht, **dadurch gekennzeichnet,** daß ein Druckmeßgerät (12) zur Messung des Istdruckes (p) im Innenraum vorgesehen ist, dem ein Druckregler (13) nachgeschaltet ist, der den Istdruck (p) mit einem vorgegebenen Sollwert (p*) vergleicht und an dessen Ausgang eine der Differenz zwischen den beiden Werten (p, p*) entsprechende Ausgangsspannung (x) anliegt, die jeweils dem ersten Eingang eines Multipliziergliedes (14 bis 17) aufgeschaltet ist, dessen zweiter Eingang jeweils mit einer vorgegebenen, dem gewünschten Anteil des einzelnen Gases an dem Gasgemisch proportionalen Spannung (y) beaufschlagt ist, und daß den Multipliziergliedern (14 bis 17) jeweils ein Regler (22 bis 25) nachgeschaltet ist, der jeweils über ein Einstellorgan (7 bis 10) den Zustrom eines der das Gemisch bildenden Gase in den Innenraum regelt.

2. Beschichtungskammer (1) nach Anspruch 1, **dadurch gekennzeichnet,** daß die dem zweiten Eingang des Multipliziergliedes (14 bis 17) zugeführte Spannung (y) jeweils einstellbar ist.

3. Beschichtungskammer (1) nach Anspruch 2, **dadurch gekennzeichnet,** daß die zugeführte Spannung (y) zeitlich variierbar ist.

## Claims

1. A coating chamber (1) with at least one cathode (28) able to be consumed by arc discharge and with a device (26) for holding objects (27), which are coated by the deposition of reaction products, which occur during the reaction of the vaporised cathode material with a gas atmosphere, wherein the gas atmosphere consists of a mixture of several gases under varying pressure (p), characterised in that a pressure meter (12) for measuring the actual pressure (p) is provided in the inner chamber, after which is connected a pressure regulator (13), which compares the actual pressure (p) to a predetermined desired value (p*) and at the output of which there is present an output voltage (x) corresponding to the difference between the two values (p,p*), which in each case is applied to the first input of multiplier member (14 to 17), the second input of which is in each case acted upon with a predetermined voltage (y) proportional to the desired proportion of the individual gas in the gas mixture, and in that in each case a regulator (22 to 25) is connected after the multiplier members (14 to 17), which regulates in each case by way of an adjusting member (7 to 10) the flow of a gas forming the mixture into the inner chamber.

2. A coating chamber (1) according to claim 1, characterised in that the voltage (y) supplied to the second input of the multiplier member (14 to 17) is in each case able to be adjusted.

3. A coating chamber (1) according to claim 2, characterised in that the supplied voltage (y) is able to be varied with time.

## Revendications

1. Chambre de revêtement (1), comprenant au moins une cathode (28) susceptible d'être consommée par décharge d'arc et un dispositif (26) de réception d'objets (27) qui sont revêtus par le dépôt de produits de réaction se formant lors de la réaction du matériau cathodique volatilisé, avec une atmosphère gazeuse, l'atmosphère gazeuse étant constituée d'un mélange de plusieurs gaz sous une pression variable (p), caractérisée en ce qu'est prévu dans l'espace intérieur un appareil de mesure de la pression (12), destiné à mesurer la pression réelle (p), en aval duquel est monté un régulateur de pression (13) qui compare la pression réelle (p) à une valeur de consigne prescrite (p*) et, à la sortie duquel est appliquée une tension de sortie (x) qui correspond à la différence entre les deux valeurs (p, p*), cette tension de sortie étant appliquée à la première entrée d'un multiplicateur (14 à 17) dont la deuxième entrée reçoit une tension (y) prescrite proportionnelle à la proportion souhaitée des gaz individuels dans le mélange gazeux, et en ce qu'il est monté en aval des multiplicateurs (14 à 17) respectivement des régulateurs (22 à 25) qui règlent, dans l'espace intérieur et par un organe de réglage (7 à 10), le courant d'alimentation en l'un des gaz formant le mélange.

2. Chambre de revêtement (1) suivant la revendication 1, caractérisée en ce que la tension (y) appliquée à la deuxième entrée du multiplicateur (14 à 17) est réglable.

3. Chambre de revêtement (1) suivant la revendication 2, caractérisée en ce que la tension (y) appliquée est variable dans le temps.